# EUROPEAN PATENT SPECIFICATION

(11) **EP 2 414 741 B1**
(45) Date of publication and mention of the grant of the patent: **03.06.2015**
(21) Application number: 10712760.7
(22) Date of filing: 01.04.2010
(51) Int. Cl.: F24F 13/22, F24F 11/00, H05K 7/20

(54) **COOLING UNIT**
KÜHLEINHEIT
UNITÉ DE REFROIDISSEMENT

(30) Priority: 03.04.2009 GB 0905871
(43) Date of publication of application: 08.02.2012
(73) Proprietor: EATON-WILLIAMS GROUP LIMITED, Edenbridge Kent TN8 6EG (GB)
(72) Inventor: LUXFORD, Mark, Kent ME7 4BW (GB); MORGAN, David, Kent TN2 5HQ (GB)
(74) Representative: Crouch, David John
(86) International application number: PCT/GB2010/000658
(87) International publication number: WO 2010/112867

(56) References cited:
- EP-A2- 2 053 911
- US-A- 4 526 011
- US-A1- 2005 122 685
- US-A1- 2008 105 412
- US-B1- 7 315 448

## Description

The present invention relates to a cooling unit comprising a first passageway through which coolant fluid is pumped when the unit is in use, and a second passageway through which coolant fluid is pumped when the unit is in use, portions of the first and second passageways being thermally coupled to one another so as to constitute a heat exchanger, the coolant fluid which passes through the said second passageway when the unit is in use being passed to at least one heat exchanger in a space which is to be cooled (see for example patent document US-A-4526011).

A problem associated with such apparatus as hitherto proposed is that it is not readily adapted to cope with a change in the ambient dew point.

If the ambient dew point changes, condensation may occur in such a fashion as to put the operation of the electronic equipment or other equipment at risk.

The present invention seeks to provide a remedy.

Accordingly, the present invention is directed to a cooling unit having a construction as set out in the opening paragraph of the present specification, in which the unit is provided with a temperature and humidity sensor or sensors connected to a control processor of the unit and located in the space when the unit is in use to enable the control processor to determine the ambient dew point of that space, the control processor being connected to control operation of the unit in dependence upon that ambient dew point, in which the unit further comprises a parameter adjuster in the said first passageway connected to the control processor to enable the latter to control operation of the unit in dependence upon the said ambient dew point by adjusting the parameter adjuster in the said first passageway to alter a parameter of coolant therein, so as to reduce the likelihood of condensation in that space when the unit is in use. The parameter adjuster may be a variable control valve or a variable pump to vary the flow rate of coolant fluid in the said first passageway although the parameter adjuster may be a temperature adjuster.

This provides an advantage that the risk of condensation is averted without upsetting the passing of coolant to the said at least one heat exchanger.

In one application of such a unit, the coolant which passes through the said second passageway when the unit is in use is passed to at least one heat exchanger associated with heat-generating electronic equipment within the space which is to be cooled.

The space occupied by the equipment may be a data centre, a telecoms centre or room, or an IT centre or room, or even a data storage equipment or room, or other room or space.

In the present specification hereinafter the word "deceeds" shall be taken to mean the opposite of "exceeds", so that for example if a parameter is below a given threshold, or falls below a given threshold, it may be considered that that parameter "deceeds" that threshold. The usual grammatical and syntactical principles shall be taken to apply to that word.

At least one temperature sensor may be provided to give an indication of the temperature of the coolant in the said second passageway, which temperature sensor is connected to the control processor to enable the latter to adjust the parameter adjuster in the first passageway to ensure that the amount by which the temperature of the coolant in the said second passageway exceeds the ambient dew point does not deceed a predetermined threshold value.

The unit may further comprise at least one selectively adjustable variable control valve or variable pump in the said second passageway to enable the amount of fluid which passes through that passageway to be selectively adjusted.

The equipment may comprise a multiplicity of server racks or blade server racks or other pieces of equipment, for example chassis or enclosures for mounting IT equipment or other equipment, in a data centre and the cooling unit may be a cooling distribution unit, coolant fluid which passes through the said second passageway when the unit is in use being distributed to a multiplicity of heat exchangers respectively associated with such a multiplicity of server or blade server racks or other pieces of equipment, for example chassis or enclosures for mounting IT equipment or other equipment.

In one preferred embodiment of the present invention, the said second passageway is part of a coolant circuit comprising a common upstream header which extends to respective locations adjacent to such a multiplicity of racks or other equipment when the unit is in use and which is provided with a multiplicity of outlets respectively connected to inlets of a multiplicity of heat exchangers when the unit is in use, and a common downstream header provided with a multiplicity of inlets respectively connected to outlets of such a multiplicity of heat exchangers when the unit is in use.

Such a construction of cooling distribution unit provides reliability in the supply of coolant to the or each heat exchanger and is suitable especially for installation at the time a data centre is being constructed.

Advantageously, each outlet from the common upstream header is provided with a selectively adjustable variable control valve to enable adjustment of fluid flow to and from a given rack or other piece of equipment to suit that rack or other piece of equipment.

In another preferred embodiment of the present invention, the unit is provided with a frame which supports the said first and second passageways and also an outlet manifold from the said second passageway and an inlet manifold to the said second passageway. Whilst such a construction of cooling distribution unit can be used for an installation at the time a data centre or other equipment room or space is being constructed, it is especially useful for retro fitting to an existing such centre, room or space.

Preferably the connections to the inlets and the outlets are by way of quick release connectors, for example bayonet connectors. Preferably each connection between an inlet or an outlet and a respective heat exchanger associated with such a rack or other piece of equipment is by way of a flexible hose having respective quick release connectors at its two ends. This provides for ease of installation.

The present invention extends to a method of cooling the air in a data centre or other centre, room or space using a cooling unit in accordance with the present invention and as set out in one or more of the preceding paragraphs.

An example of a cooling distribution unit made in accordance with the present invention will now be described in greater detail with reference to the accompanying drawings, in which:
- Figure 1: is a perspective view of a cooling distribution unit embodying the present invention viewing it from the front and to one side;
- Figure 2: is a perspective view of the unit shown in Figure 1 viewing it from the rear and from the other side;
- Figure 2a: shows in exploded form a first modification of the unit shown in Figures 1 and 2;
- Figure 2b: shows in exploded form a second modification of the unit shown in Figures 1 and 2;
- Figure 3: shows a perspective view from one side and from above of a data centre incorporating a cooling distribution unit as shown in Figures 1 and 2; and
- Figure 4: shows both a fluid circuit and an electronic circuit of the cooling distribution unit shown in Figures 1, 2 and 3.

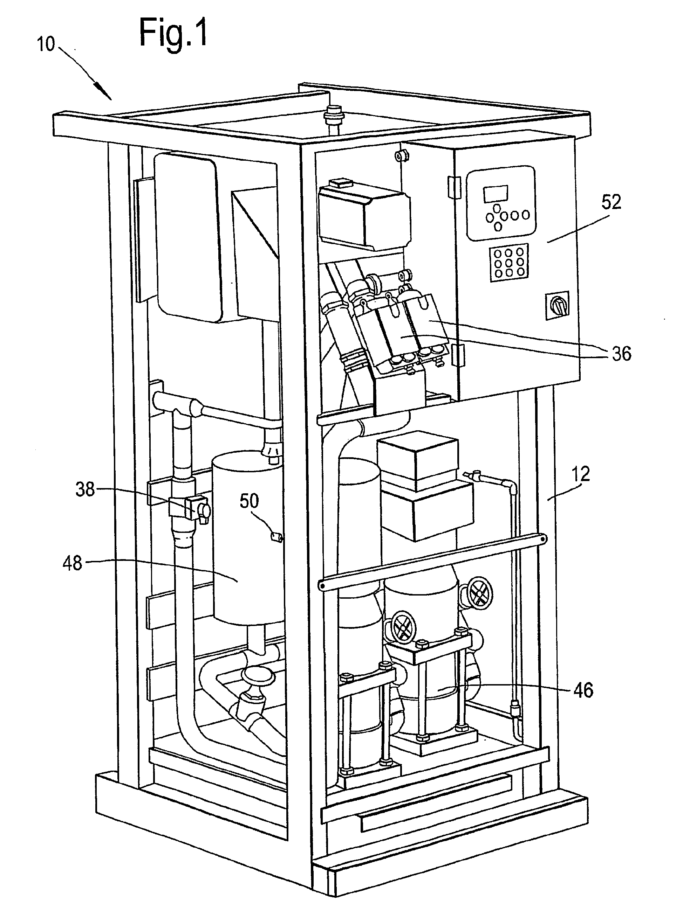

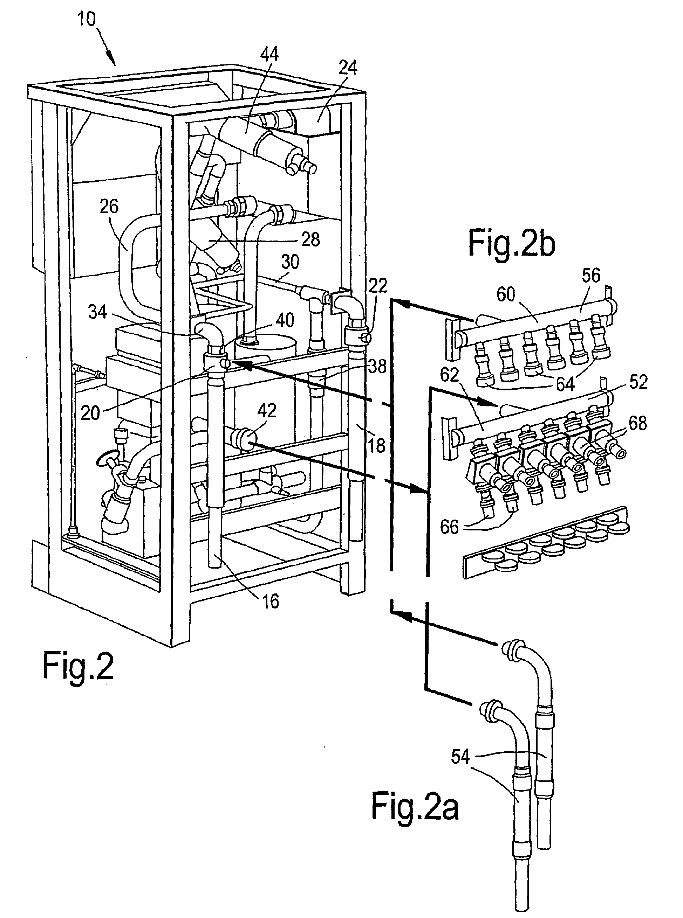

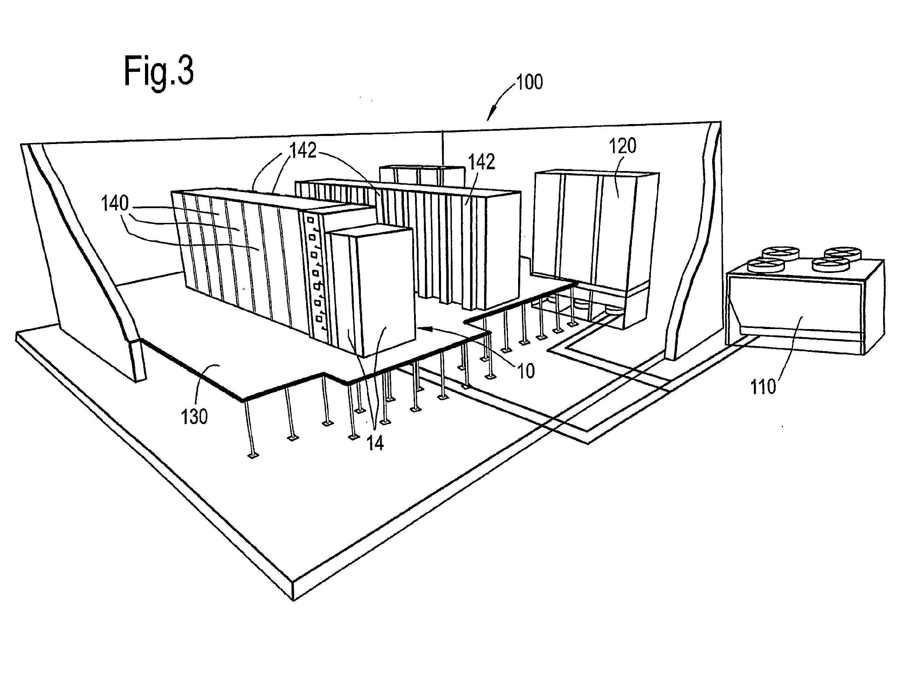

The cooling distribution unit 10 shown in Figures 1 and 2 comprises a metal frame 12 enclosed in sheet metal panelling 14 (shown in Figure 3, but not shown in Figures 1 and 2 to enable the component parts of the unit to be revealed).

The frame 12 supports a primary circuit inlet 16 and a primary circuit outlet 18 connected via respective isolation valves 20 and 22 to a plate heat exchanger 24 via a primary circuit passageway 26 (shown more clearly in Figure 3) which includes portions of the heat exchanger 24. The primary circuit inlet 16 is connected to the plate heat exchanger 24 via a filter 28. A bypass circuit 30 having a shut-off valve 34 interconnects the primary circuit inlet and outlet 16 and 18 downstream and upstream respectively of the isolation valves 20 and 22, to bypass the heat exchanger 24. The primary circuit outlet 18 is connected to the plate heat exchanger 24 via primary circuit variable control valves 36 connected in parallel with one another, one acting as a standby for the other, and via a primary circuit flowmeter 38.

The unit 10 is also provided with a secondary circuit inlet 40 and a secondary circuit outlet 42 connected to the plate heat exchanger 24 via a secondary circuit passageway 43 which includes portions of the heat exchanger 24. The inlet 40 is connected via an optional secondary circuit filter 44 to the plate heat exchanger 24. The secondary circuit outlet 42 is connected to the heat exchanger 24 via run and standby secondary variable control pumps 46 which are in parallel with one another, and a secondary circuit reservoir tank 48 provided with a level switch 50.

The control valves 36, the flowmeter 38, the secondary circuit pumps 46, and the level switch 50 are all electronically connected to a control and display unit 52.

The secondary circuit inlet and outlet 40 and 42 respectively may be connected to respective flexible tailpipes 54 (shown in Figure 2a) which extend downwardly to respective under-floor manifolds (shown in Figure 2a).

Alternatively, the secondary circuit inlet and outlet 40 and 42 may be connected directly to respective manifolds 56 and 58, as shown in Figure 2b. These manifolds have respective common chambers 60 and 62 and respective sets of quick release couplings 64 and 66. The quick release couplings 66 of the secondary circuit outlet or supply manifold 58 are provided with respective control valves 68.

Figure 3 shows a data centre 100 provided with a chiller unit 110 connected to supply cooled water to perimeter cooling 120 and also to the primary circuit of the cooling distribution unit 10. The latter is provided with flexible tailpipes 54 as shown in Figure 2a (but not visible in Figure 3) and under raised flooring 130 of the data centre 100. The cooling distribution unit 10 is provided with manifolds like those shown in Figure 2b but connected to the ends of the flexible tailpipes 54 which are further from the cooling distribution unit 10. The data centre 100 is provided with rows of server or blade server racks 140, the blade racks 140 being provided with respective rear door heat exchangers 142. Each of up to six rear door heat exchangers 142 of respective server or blade server racks 140 are connected to the secondary circuit of the cooling distribution unit 10 via respective outlets 66 and inlets 64 thereof (again not visible in Figure 3).

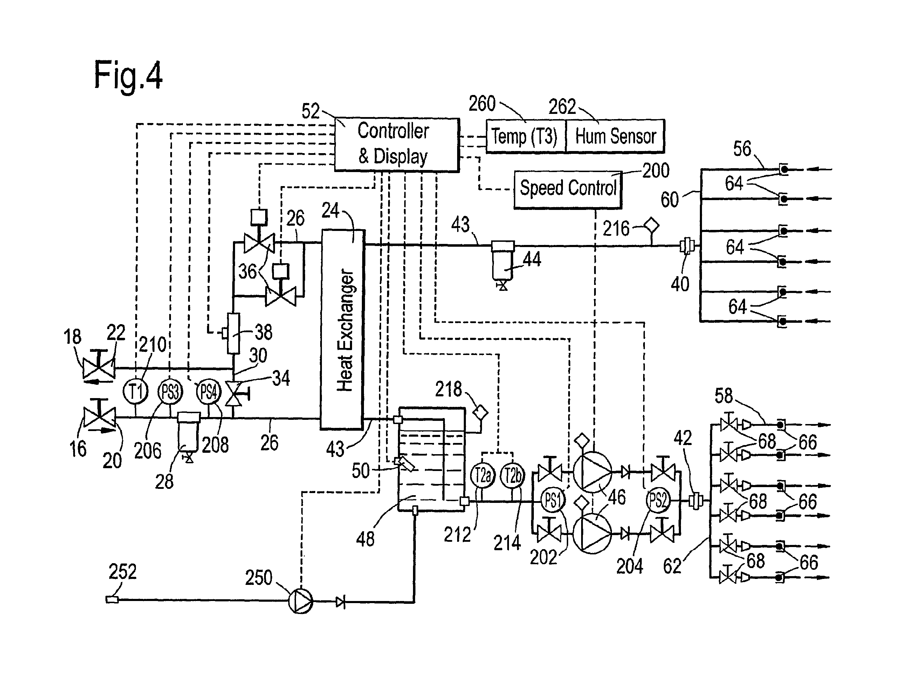

The fluid and electrical circuitry of the cooling distribution unit 10 shown in Figures 1 to 3 is shown more clearly in Figure 4 in which parts corresponding to what is shown in Figures 1 and 2 are given the same reference numerals as in Figures 1 and 2.

Additional components of the cooling distribution unit 10, more readily apparent from Figure 4, comprise a speed controller 200 electrically connected between the control and display unit 52 and the pumps 46, pressure meters 202, 204, 206 and 208 all connected to the control and display unit 52 and located to measure the pressure of the coolant flowing immediately upstream and downstream respectively of the pumps 46 and upstream and downstream respectively of the filter 28. Thermometers 210, 212, 214 are also connected electrically to the control and display unit 52 and are located to provide a measure of the temperature of coolant flowing immediately upstream of the filter 28 and of coolant flowing at two spaced apart locations downstream of the secondary circuit reservoir tank 48 but upstream of the pumps 46.

Air eliminators 216, 218 are provided respectively at locations downstream of the secondary circuit inlet 40 and in the reservoir tank 48.

A filling pump 250 is connected to pump cooling fluid from a source 252 thereof into the reservoir tank 48.

A thermometer or other temperature sensor 260 located in the data centre 100 when the unit 10 is in use is connected to the control and display unit 52, as is a temperature and humidity sensor 260 and 262.

With the cooling distribution unit 10 and other apparatus connected as shown in Figures 3 and 4, the equipment operates as follows.

The chiller 110 provides cool water for the primary circuit of the cooling distribution unit 10 and also for the perimeter cooling 120. At the same time, that one of the pumps 46 for the time being acting as the main pump supplies water from the reservoir tank 48 to the output 42 of the unit 10 and, via respective outlets of the manifold 58 to respective rear door heat exchangers 142 of the blade racks 140. Water from the rear door heat exchangers 142 is returned via piping (not shown) to respective inlets of the manifold 60 to the cooling distribution unit 10 where it passes via the filter 44 to the plate heat exchanger 24 and back to the reservoir tank 48. In the event that the liquid level in the latter as sensed by the level sensor 70 deceeds a predetermined threshold level stored in the control and display unit 52, the tank is replenished by water from the source 252 via the pump 250.

The flow control valve 68, and the speed of the pump 46 are adjusted as appropriate for the respective rear door heat exchangers cooled by the water in the secondary circuit.

The control and display unit 52 continuously monitors temperature and humidity of the data centre by way of the temperature and humidity sensor 260 and 262. The control and display unit 52 in turn determines the dew point in the data centre based on measurements from the humidity sensor 262 and assuming a pressure of substantially one atmosphere for the air in the data centre. The temperature of air in the data centre, more especially air close to the ceiling thereof, is monitored by the control and display unit 52 by virtue of its connection to the appropriately located thermometer or temperature sensor 260. The temperature of the water immediately downstream of the secondary circuit reservoir tank is monitored by way of either of the thermometers 212 and 214 and the control and display unit 52. In the event that the temperature difference between the temperature at thermometer 212 or 214 and the ambient dew point deceeds a predetermined safe threshold value, the control valves 36 are partially closed by the control and display unit 52 to raise the temperature of the water in the secondary circuit, to increase the temperature difference and reduce the likelihood of condensation in the rear door heat exchangers 142, whilst maintaining an adequate cooling effect.

Numerous variations and modifications to the illustrated cooling distribution unit may occur to a reader of the specification without taking the unit outside the scope of the present invention. To give one example only, the control and display unit 52 may also be provided with an input from a pressure sensor (not shown) also located within the data centre, and the control and display unit 52 may be further programmed to calculate the dew point more accurately on the basis of the inputs from both its humidity sensor and such a pressure sensor. The control valves 36 may be replaced or supplemented by control pumps, and the control pumps 46 may be supplemented by control valves or replaced by control valves if for example a single pump is provided in a non-branched part of the passageway 43. The variable control valves 36 may be replaced by or supplemented by variable control pumps, and the variable control pumps 46 may be replaced or supplemented by variable control valves.

Optionally, an atmospheric pressure sensor (e.g., a barometer) may be added to directly measure the pressure in the closed environment of the data centre. Measurements from the pressure sensor and from the humidity sensor 262 may be provided to the control and display unit 52 which calculates the dew point based on the humidity and pressure in the closed environment.

## Claims

1. A cooling unit (10) comprising a first passageway (26) through which coolant fluid is pumped when the unit is in use, and a second passageway (43) through which coolant fluid is pumped when the unit is in use, portions of the first and second passageways being thermally coupled to one another so as to constitute a heat exchanger (24), the coolant fluid which passes through the said second passageway (43) when the unit is in use being passed to at least one heat exchanger in a space (100) which is to be cooled, wherein the unit (10) is provided with a temperature and humidity sensor or sensors (260 and 262) connected to a control processor (52) of the unit (10) and located in the space (100) to be cooled when the unit (10) is in use to enable the control processor (52) to determine the ambient dew point of that space (100), the control processor (52) being connected to control operation of the unit (10) in dependence upon that ambient dew point, **characterised in that** the unit (10) further comprises a parameter adjuster (36) in the said first passageway (26) connected to the control processor (52) to enable the latter to control operation of the unit in dependence upon the said ambient dew point by adjusting the parameter adjuster in the said first passageway (26) to alter a parameter of the coolant therein, so as to reduce the likelihood of condensation occurring **in that** space when the unit is in use.

2. A cooling unit according to claim 1, **characterised in that** the coolant which passes through the said second passageway (43) when the unit is in use is passed to at least one heat exchanger (142) associated with heat-generating electronic equipment (140) which is to be cooled.

3. A cooling unit according to claim 1 or claim 2, **characterised in that** at least one temperature sensor (212 or 214) is provided to give an indication of the temperature of the coolant in the said second passageway (43), which temperature sensor (212 or 214) is connected to the control processor (52) to enable the latter to adjust the parameter adjuster in the first passageway (26) to ensure that the amount by which the temperature of the coolant in the said second passageway (43) exceeds the ambient dew point does not deceed a predetermined threshold value.

4. A cooling unit according to any preceeding claim, **characterised in that** the unit further comprises at least one selectively adjustable variable control valve or variable pump (46) in the said second passageway (43) to enable the amount of fluid which passes through that passageway (43) to be selectively adjusted.

5. A cooling unit according to claim 2, or claim 3 or 4 when read as appended to claim 2, **characterised in that** the equipment with which the said at least one heat exchanger (142) is associated comprises a multiplicity of server racks or blade server racks in a data centre or other pieces of equipment within a given space, the cooling unit (10) being a cooling distribution unit, coolant fluid which passes through the said second passageway (43) when the unit is in use being distributed to a multiplicity of heat exchangers (142) respectively associated with such a multiplicity of racks or other pieces of equipment.

6. A cooling unit according to claim 5, **characterised in that** the said second passageway (43) is part of a coolant circuit comprising a common upstream header (62) which extends to respective locations adjacent to such a multiplicity of racks (140) or other pieces of equipment when the unit (10) is in use and which is provided with a multiplicity of outlets (66) respectively connected to inlets of such a multiplicity of heat exchangers (142) when the unit (10) is in use, and a common downstream header (60) provided with a multiplicity of inlets (64) respectively connected to outlets of such a multiplicity of heat exchangers (142) when the unit (10) is in use.

7. A cooling unit according to claim 6, **characterised in that** each outlet (66) from the common upstream header (62) is provided with a selectively adjustable variable control valve (68) to enable adjustment of fluid flow to and from a given rack (140) or other piece of equipment to suit that rack or other piece of equipment.

8. A cooling unit according to claim 6 or claim 7, **characterised in that** the connections to the inlets (64) and the outlets (66) comprise quick release connectors.

9. A cooling unit according to claim 8, **characterised in that** the quick release connectors comprise bayonet connectors (64, 66).

10. A cooling unit according to any one of claims 6 to 10, **characterised in that** each connection between an inlet (64) or an outlet (66) and a respective heat exchanger (142) associated with such a rack (140) or other piece of equipment is by way of a flexible hose having respective quick release connectors at its two ends.

11. A cooling unit according to any preceding claim, **characterised in that** the unit (10) is provided with a frame (12) which supports the said first and second passageways (26 and 43) and also an outlet manifold (58) from the said second passageway (43) and an inlet manifold (56) to the said second passageway (43).

12. A cooling unit according to any preceding claim, **characterised in that** the parameter adjuster (36) comprises a variable control valve (36) or a variable pump, and the parameter is the flow rate of coolant in the said first passageway.

13. A method of cooling the air in a space (100), comprising pumping coolant fluid through first and second passageways (26, 43) having respective portions thermally coupled to one another by way of a heat exchanger (24), and distributing the coolant fluid in the second passageway (43) to at least one heat exchanger (142) for cooling the air in the space (100), wherein the ambient dew point of the space (100) is monitored by means of a temperature and humidity sensor or sensors (260 and 262) connected to deliver a signal to a control processor (52) and located in the space (100), **characterised in that** the rate of flow of coolant in the first passageway (26) is controlled by means of a parameter adjuster (36) therein connected to be operated by the control processor (52) in dependence upon the signal it receives from the temperature and humidity sensor or sensors (260 and 262), so as to reduce the likelihood of condensation occurring in the space (100).

14. A method according to claim 13, further comprising monitoring the temperature of the coolant in the said second passageway (43) by means of a temperature sensor (212 or 214) provided for that purpose and connected to deliver a signal to the control processor (52), and adjusting the parameter adjuster by means of the control processor (52) in dependence upon the signal it receives from the temperature sensor (212 or -214) to ensure that the amount by which the temperature of the coolant in the second passageway (43) exceeds the ambient dew point does not deceed a predetermined threshold value.

15. A method of cooling air in a space (100) using a cooling unit (10) as claimed in any one of claims 1 to 12.

## Patentansprüche

1. Kühleinheit (10), umfassend einen ersten Durchgang (26), durch die ein Kühlmittel gepumpt wird, wenn die Einheit im Einsatz ist, sowie einen zweiten Durchgang (43), durch die ein Kühlmittel gepumpt wird, wenn die Einheit im Einsatz ist, wobei Abschnitte des ersten und zweiten Durchgangs thermisch miteinander gekoppelt sind, so dass sie einen Wärmetauscher (24) bilden, und das Kühlmittel, das den zweiten Durchgang (43) durchströmt, wenn die Einheit im Einsatz ist, an wenigstens einen Wärmetauscher in einem zu kühlenden Raum (100) weitergeleitet wird, wobei die Einheit (10) mit einem Temperatur- und Feuchtigkeitssensor oder -sensoren (260 und 262) versehen ist, die mit einem Steuerprozessor (52) der Einheit (10) verbunden und in dem zu kühlenden Raum (100) angeordnet sind, wenn die Einheit (10) im Einsatz ist, damit der Steuerprozessor (52) den Umgebungstaupunkt dieses Raumes (100) ermitteln kann, wobei der Steuerprozessor (52) verbunden ist, um den Betrieb der Einheit (10) in Abhängigkeit von diesem Umgebungstaupunkt zu steuern, **dadurch gekennzeichnet, dass** die Einheit (10) des Weiteren im ersten Durchgang (26) eine Parametereinstellvorrichtung (36) umfasst, die mit dem Steuerprozessor (52) verbunden ist, damit dieser den Betrieb der Einheit in Abhängigkeit vom Umgebungstaupunkt steuern kann, indem die Parametereinstellvorrichtung im ersten Durchgang (26) zur Änderung eines Parameters des darin enthaltenen Kühlmittels eingestellt wird, um die Wahrscheinlichkeit einer Kondensation zu verringern, die in diesem Raum auftritt, wenn die Einheit im Einsatz ist.

2. Kühleinheit nach Anspruch 1, **dadurch gekennzeichnet, dass** das Kühlmittel, das den zweiten Durchgang (43) durchströmt, wenn die Einheit im Einsatz ist, an wenigstens einen Wärmetauscher (142) weitergeleitet wird, der an eine zu kühlende wärmeerzeugende elektronische Ausrüstung (140) angegliedert ist.

3. Kühleinheit nach Anspruch 1 oder 2, **dadurch gekennzeichnet, dass** wenigstens ein Temperatursensor (212 oder 214) vorgesehen ist, um die Temperatur des Kühlmittels im zweiten Durchgang (43) anzuzeigen, wobei der Temperatursensor (212 oder 214) mit dem Steuerprozessor (52) verbunden ist, damit dieser die Parametereinstellvorrichtung im ersten Durchgang (26) einstellen kann, um sicherzustellen, dass die Höhe, um die die Temperatur des Kühlmittels im zweiten Durchgang (43) den Umgebungstaupunkt überschreitet, einen vorgegebenen Schwellenwert nicht unterschreitet.

4. Kühleinheit nach einem der vorstehenden Ansprüche, **dadurch gekennzeichnet, dass** die Einheit des Weiteren wenigstens ein selektiv einstellbares, variables Steuerventil oder eine selektiv einstellbare, variable Pumpe (46) im zweiten Durchgang (43) umfasst, damit die Flüssigkeitsmenge, die diesen Durchgang (43) durchströmt, selektiv eingestellt werden kann.

5. Kühleinheit nach Anspruch 2 oder Anspruch 3 oder 4, soweit sich diese auf Anspruch 2 beziehen, **dadurch gekennzeichnet, dass** die Ausrüstung, an die der wenigstens eine Wärmetauscher (142) angegliedert ist, eine Vielzahl von Server-Racks oder Bladeserver-Racks in einem Rechenzentrum oder sonstigen Ausrüstungsteilen in einem gegebenen Raum umfasst und die Kühleinheit (10) eine Kühlungsverteilungseinheit ist, wobei das Kühlmittel, das den zweiten Durchgang (43) durchströmt, wenn die Einheit im Einsatz ist, an eine Vielzahl von Wärmetauschern (142) verteilt wird, die jeweils an die Vielzahl von Racks oder sonstigen Ausrüstungsteilen angegliedert ist.

6. Kühleinheit nach Anspruch 5, **dadurch gekennzeichnet, dass** der zweite Durchgang (43) einen Teil eines Kühlmittelkreislaufs bildet, der einen gemeinsamen vorgeschalteten Sammler (62) umfasst, der sich zu jeweiligen an die Vielzahl von Racks (140) oder sonstigen Ausrüstungsteilen angrenzenden Positionen erstreckt, wenn die Einheit (10) im Einsatz ist, und der mit einer Vielzahl von Austrittsöffnungen (66) versehen ist, die jeweils mit Eintrittsöffnungen der Vielzahl von Wärmetauschern (142) verbunden ist, wenn die Einheit (10) im Einsatz ist, und einen gemeinsamen nachgeschalteten Sammler (60) umfasst, der mit einer Vielzahl von Eintrittsöffnungen (64) versehen ist, die jeweils mit Austrittsöffnungen der Vielzahl von Wärmetauschern (142) verbunden ist, wenn die Einheit (10) im Einsatz ist.

7. Kühleinheit nach Anspruch 6, **dadurch gekennzeichnet, dass** jede Austrittsöffnung (66) aus dem gemeinsamen vorgeschalteten Sammler (62) mit einem selektiv einstellbaren, variablen Steuerventil (68) versehen ist, um eine Einstellung des Flüssigkeitsstroms zu und von einem bestimmten Rack (140) oder einem sonstigen Ausrüstungsteil zu ermöglichen, so dass er für dieses Rack oder sonstige Ausrüstungsteil geeignet ist.

8. Kühleinheit nach Anspruch 6 oder Anspruch 7, **dadurch gekennzeichnet, dass** die Verbindungen zu den Eintrittsöffnungen (64) und den Austrittsöffnungen (66) Schnellanschlüsse umfassen.

9. Kühleinheit nach Anspruch 8, **dadurch gekennzeichnet, dass** die Schnellanschlüsse Bajonettanschlüsse (64, 66) umfassen.

10. Kühleinheit nach einem der Ansprüche 6 bis 10, **dadurch gekennzeichnet, dass** jede Verbindung zwischen einer Eintrittsöffnung (64) oder einer Austrittsöffnung (66) und einem jeweiligen an ein solches Rack (140) oder ein sonstiges Ausrüstungsteil angegliederten Wärmetauscher (142) mittels eines flexiblen Schlauchs erfolgt, der an seinen beiden Enden jeweilige Schnellanschlüsse aufweist.

11. Kühleinheit nach einem der vorstehenden Ansprüche, **dadurch gekennzeichnet, dass** die Einheit (10) mit einem Rahmen (12) versehen ist, der den ersten und zweiten Durchgang (26 und 43) und ferner ein Austrittssammelrohr (58) vom zweiten Durchgang (43) und ein Eintrittssammelrohr (56) zum zweiten Durchgang (43) trägt.

12. Kühleinheit einem der vorstehenden Ansprüche, **dadurch gekennzeichnet, dass** die Parametereinstellvorrichtung (36) ein variables Stellventil (36) oder eine variable Pumpe umfasst und der Parameter die Durchflussmenge des Kühlmittels im ersten Durchgang ist.

13. Verfahren zur Kühlung von Luft in einem Raum (100), umfassend: Pumpen eines Kühlmittels durch einen ersten und zweiten Durchgang (26, 43), die jeweilige Abschnitte aufweisen, die über einen Wärmetauscher (24) thermisch miteinander gekoppelte sind, und Verteilen des Kühlmittels im zweiten Durchgang (43) an wenigstens einen Wärmetauscher (142) zur Kühlung der Luft in dem Raum (100), wobei der Umgebungstaupunkt des Raumes (100) mittels eines Temperatur- und Feuchtigkeitssensors oder -sensoren (260 und 262) überwacht wird, die verbunden sind, um ein Signal an einen Steuerprozessor (52) zu liefern, und die in dem Raum (100) angeordnet sind, **dadurch gekennzeichnet, dass** die Durchflussmenge des Kühlmittels im ersten Durchgang (26) mittels einer Parametereinstellvorrichtung (36) gesteuert wird, die verbunden ist, um vom Steuerprozessor (52) in Abhängigkeit von dem Signal, das dieser von dem/den Temperatur- und Feuchtigkeitssensor oder -sensoren (260 und 262) empfängt, betrieben zu werden, so dass sich die Wahrscheinlichkeit einer in dem Raum (100) auftretenden Kondensation verringert.

14. Verfahren nach Anspruch 13, des Weiteren umfassend: Überwachung der Temperatur des Kühlmittels im zweiten Durchgang (43) mittels eines Temperatursensors (212 oder 214), der zu diesem Zweck vorgesehen ist und verbunden ist, um ein Signal an den Steuerprozessor (52) zu liefern, und Einstellung der Parametereinstellvorrichtung mittels des Steuerprozessors (52) in Abhängigkeit von dem Signal, das dieser von dem Temperatursensor (212 oder 214) empfängt, um sicherzustellen, dass die Höhe, um die die Temperatur des Kühlmittels im zweiten Durchgang (43) den Umgebungstaupunkt überschreitet, einen vorgegebenen Schwellenwert nicht unterschreitet.

15. Verfahren zur Kühlung von Luft in einem Raum (100) unter Verwendung einer Kühleinheit (10) nach einem der Ansprüche 1 bis 12.

## Revendications

1. Une unité de refroidissement (10) comprenant un premier passage (26) au travers duquel un fluide de refroidissement est pompé lorsque l'unité est en utilisation, et un second passage (43) au travers duquel un fluide de refroidissement est pompé lorsque l'unité est en utilisation, des portions du premier et du second passages étant thermiquement couplées l'une à l'autre de manière à constituer un échangeur thermique (24), le fluide de refroidissement, qui passe au travers dudit second passage (43) lorsque l'unité est en utilisation, étant passé dans au moins un échangeur thermique dans un espace (100) qui doit être refroidi, **dans lequel** l'unité (10) est dotée d'un capteur ou de capteurs de température et d'humidité (260 et 262) connectés à un processeur de contrôle (52) de l'unité (10) et localisée dans l'espace (100) à refroidir lorsque l'unité (10) est en utilisation pour activer le processeur der contrôle (52) afin qu'il détermine le point de rosée ambiant de cet espace (100), le processeur de contrôle (52) étant connecté pour contrôler le fonctionnement de l'unité (10) en fonction de ce point de rosée ambiant, **caractérisé en ce que** l'unité (10) comprend en outre un ajusteur de paramètre (36) dans ledit premier passage (26) connecté au processeur de contrôle (52) pour permettre à ce dernier de contrôler le fonctionnement de l'unité en fonction dudit point de rosée ambiant en ajustant l'ajusteur de paramètre dans ledit premier passage (26) pour modifier un paramètre du fluide de refroidissement qui s'y trouve, de façon à réduire la probabilité de condensation intervenant dans cet espace lorsque l'unité est en utilisation.

2. Unité de refroidissement selon la revendication 1, **caractérisée en ce que** le liquide de refroidissement qui passe au travers dudit second passage (43), lorsque l'unité est en utilisation, est passé vers au moins un échangeur thermique (142) associé à l'équipement électronique de génération de chaleur (140) qui doit être refroidi.

3. Unité de refroidissement selon la revendication 1 ou la revendication 2, **caractérisée en ce qu**'au moins un capteur de température (212 ou 214) est fourni pour donner une indication de la température du liquide de refroidissement dans ledit second passage (43), lequel capteur de température (212 ou 214) est connecté au processeur de contrôle (52) pour permettre à ce dernier d'ajuster l'ajusteur de paramètre dans le premier passage (26) pour s'assurer que la quantité avec laquelle la température du liquide de refroidissement dans ledit second passage (43) excède le point de rosée ambiant, n'est pas inférieure à une valeur seuil prédéterminée.

4. Unité de refroidissement selon l'une quelconque des revendications précédentes, **caractérisée en ce que** l'unité comprend en outre au moins une vanne de contrôle variable ajustable sélectivement ou une pompe variable (46) dans ledit second passage (43) pour permettre à la quantité de fluide qui passe dans ce passage (43) d'être ajustée de façon sélective.

5. Unité de refroidissement selon la revendication 2, ou la revendication 3 ou 4 lorsqu'elles sont lues comme dépendantes de la revendication 2, **caractérisée en ce que** l'équipement, auquel ledit échangeur thermique au nombre d'au moins un (142) est associé, comprend une multiplicité de baies serveur ou de baies de serveur lame dans un centre de données ou autres éléments d'équipement dans un espace donné, l'unité de refroidissement (10) étant une unité de distribution de refroidissement, un fluide de refroidissement qui passe au travers dudit second passage (43) lorsque l'unité est en utilisation, étant distribué vers une multiplicité d'échangeurs thermiques (142) respectivement associés à une telle multiplicité de baies ou autres éléments d'équipement.

6. Unité de refroidissement selon la revendication 5, **caractérisée en ce que** ledit second passage (43) fait partie d'un circuit de refroidissement comprenant un collecteur amont commun (62) qui s'étend vers des emplacements respectifs adjacents à une telle multiplicité de baies (140) ou autres éléments d'équipement lorsque l'unité (10) est en utilisation et qui est pourvu d'une multiplicité de sorties (66) respectivement connectées à des entrées d'une telle multiplicité d'échangeurs thermiques (142) lorsque l'unité (10) est en utilisation, et un collecteur aval commun (60) doté d'une multiplicité d'entrées (64) respectivement connectées à des sorties d'une telle multiplicité d'échangeurs thermiques (142) lorsque l'unité (10) est en utilisation.

7. Unité de refroidissement selon la revendication 6, **caractérisée en ce que** chaque sortie (66) du collecteur aval commun (62) est doté d'une vanne de contrôle variable ajustable sélectivement (68) pour permettre l'ajustement du débit de fluide vers et depuis une baie donnée (140) ou autre élément d'équipement pour s'adapter à cette baie ou cet autre élément d'équipement.

8. Unité de refroidissement selon la revendication 6 ou la revendication 7, **caractérisée en ce que** les connexions vers les entrées (64) et les sorties (66) comprennent des connecteurs à libération rapide.

9. Unité de refroidissement selon la revendication 8, **caractérisée en ce que** les connecteurs à libération rapide comprennent des connecteurs à baïonnette (64, 66).

10. Unité de refroidissement selon l'une quelconque des revendications 6 à 10, **caractérisée en ce que** chaque connexion entre une entrée (64) ou une sortie (66) et un échangeur thermique respectif (142) associé à une telle baie (140) ou autre élément d'équipement se fait par le biais d'un tuyau souple ayant des connecteurs à
libération rapide respectifs à ses deux extrémités.

11. Unité de refroidissement selon l'une quelconque des revendications précédentes, **caractérisée en ce que** l'unité (10) est fournie avec un châssis (12) qui supporte lesdits premier et second passages (26 et 43) et aussi une tubulure de sortie (58) depuis ledit second passage (43) et une tubulure d'entrée (56) vers ledit second passage (43).

12. Unité de refroidissement selon l'une quelconque des revendications précédentes, **caractérisée en ce que** l'ajusteur de paramètre (36) comprend une vanne de contrôle variable (36) ou une pompe variable, et le paramètre est le débit de liquide de refroidissement dans ledit premier passage.

13. Méthode de refroidissement de l'air dans un espace (100), comprenant le pompage d'un fluide de refroidissement au travers d'un premier et d'un second passages (26, 43) ayant des portions respectives couplées thermiquement l'une à l'autre par le biais d'un échangeur thermique (24), et la distribution du fluide de refroidissement dans le second passage (43) vers au moins un échangeur thermique (142) pour refroidir l'air dans l'espace (100), **dans lequel** le point de rosée ambiant de l'espace (100) est supervisé au moyen d'un capteur ou de capteurs de température et d'humidité (260 et 262) connectés pour délivrer un signal à un processeur de contrôle (52) et localisés dans l'espace (100), **caractérisé en ce que** le débit de liquide de refroidissement dans le premier passage (26) est contrôlé au moyen d'un ajusteur de paramètre (36) connecté à lui pour être actionné par le processeur de contrôle (52) en fonction du signal qu'il reçoit du ou des capteurs de température et d'humidité (260 et 262), de façon à réduire la probabilité de condensation dans l'espace (100).

14. Méthode selon la revendication 13, comprenant en outre la supervision de la température du liquide de refroidissement dans ledit second passage (43) au moyen d'un capteur de température (212 ou 214) prévu à cet effet et connecté pour délivrer un signal au processeur de contrôle (52), et ajuster l'ajusteur de paramètre au moyen du processeur de contrôle (52) en fonction du signal qu'il reçoit du capteur de température (212 ou 214) pour assurer que la quantité avec laquelle la température du liquide de refroidissement dans le second passage (43) excède le point de rosée ambiant, n'est pas inférieure à une valeur seuil prédéterminée.

15. Méthode pour refroidir l'air dans un espace (100) en utilisant une unité de refroidissement (10) telle que revendiquée dans l'une quelconque des revendications 1 à 12.
